# EUROPEAN PATENT APPLICATION

(11) **EP 4 539 108 A1**
(43) Date of publication of application: **16.04.2025**
(21) Application number: 23819571.3
(22) Date of filing: 10.05.2023
(51) Int. Cl.: H01L 21/365, C23C 16/40, C23C 16/448, C23C 16/455, C30B 25/18, C30B 29/16, H01L 21/368

(54) **FILM FORMATION METHOD AND FILM FORMATION DEVICE**

(30) Priority: 08.06.2022 JP 2022093118
(71) Applicant: SHIN-ETSU CHEMICAL CO., LTD., Tokyo 1000005 (JP)
(72) Inventor: WATABE, Takenori, Annaka-shi, Gunma 379-0195 (JP); SAKATSUME, Takahiro, Annaka-shi, Gunma 379-0195 (JP)
(74) Representative: Sonnenhauser, Thomas Martin
(86) International application number: PCT/JP2023/017578
(87) International publication number: WO 2023/238587

(57) **Abstract**

The present invention is a film forming method that sprays mist on a heated substrate from a nozzle to form a crystalline oxide film by a mist CVD method, wherein the nozzle for use in the method includes at least two or more opposing gas inlets, a gas mixing unit having the gas inlets, and a gas outlet from which the mist is sprayed, and a linear velocity L (cm/sec) of the mist at any one of the two or more opposing gas inlets satisfies L≥0.8V-200, wherein V (cm³) represents a volume of the gas mixing unit. This can provide a film forming method for forming a crystalline oxide film, that has excellent crystallinity and a favorable in-plane film thickness distribution even with a large area and a thin film thickness, and has excellent semiconductor properties when applied to a semiconductor device; and a film forming apparatus for performing the film forming method.

## Description

### TECHNICAL FIELD

The present invention relates to a film forming method and a film forming apparatus.

### BACKGROUND ART

As next generation switching devices capable of achieving high voltage, low loss, and high heat resistance, semiconductor devices using gallium oxide (Ga₂O₃) with a wide bandgap have attracted attention, and are expected to be applied to power semiconductor devices such as inverters. Additionally, because of its wide bandgap, gallium oxide is also expected to be widely applied as light receiving/emitting devices such as LED and sensors. Particularly, by using indium or aluminum alone or in combination to prepare a mixed crystal thereof, it is possible to control a bandgap of gallium oxide having a corundum structure such as α-Ga₂O₃. Therefore, InAlGaO-based semiconductors constitute an extremely attractive material system. The InAlGaO-based semiconductor herein refers to In_{X}Al_{Y}Ga_{Z}O₃ (0≤X≤2, 0≤Y≤2, 0≤Z≤2, X+Y+Z=1.5 to 2.5), and can be comprehensively regarded as the same material system including gallium oxide.

However, since the most stable phase of gallium oxide has a β-gallia structure, it is difficult to form a crystal film having a corundum structure as a metastable phase without using a special deposition method. For example, crystal growth conditions are also often limited to heteroepitaxial growth, etc., and thus dislocation density tends to be increased. Furthermore, regardless of a crystal film having a corundum structure, there still remain a number of problems, such as enhancement of a deposition rate and crystal quality, prevention of cracks and abnormal growth, suppression of twinning, and cracking of a substrate due to warping. Under such circumstances, some studies are currently being conducted on deposition of a crystalline semiconductor having a corundum structure.

Patent Document 1 describes a method for producing an oxide crystal thin film by a mist CVD method using bromide or iodide of gallium or indium. Patent Documents 2 to 4 describe a multilayer structure in which a semiconductor layer having a corundum crystal structure and an insulating film having a corundum crystal structure are laminated on a base substrate having a corundum crystal structure. Furthermore, as described in Patent Documents 5 to 7, deposition by a mist CVD method using an ELO substrate or void formation has also been considered.

Patent Document 8 describes deposition of gallium oxide having a corundum structure by halide vapor phase epitaxy (HVPE technique) using at least a gallium raw material and an oxygen raw material. Furthermore, Patent Document 9 describes ELO crystal growth using a substrate having a formed pattern to obtain a crystal film having a surface area of 9 µm² or more and dislocation density of 5×10⁶ cm⁻² or less.

### CITATION LIST

### PATENT LITERATURE

Patent Document 1: JP 5397794 B2
Patent Document 2: JP 5343224 B2
Patent Document 3: JP 5397795 B2
Patent Document 4: JP 2014-072533 A
Patent Document 5: JP 2016-100592 A
Patent Document 6: JP 2016-098166 A
Patent Document 7: JP 2016-100593 A
Patent Document 8: JP 2016-155714 A
Patent Document 9: JP 2019-034883 A
Patent Document 10: WO 2021/065940 A1

### SUMMARY OF INVENTION

### TECHNICAL PROBLEM

However, gallium oxide has a problem with heat dissipation. To solve the problem of heat dissipation, for example, gallium oxide should have a thin film thickness of 30 µm or less. This leads to a problem of a complicated polishing process and an increased cost. Additionally, in the first place, when a gallium oxide film is polished to have a thin thickness, there has been a problem of difficulty in obtaining the large-area gallium oxide film while maintaining a film thickness distribution. Furthermore, when applied to vertical devices, the series resistance is not fully satisfactory. Therefore, to allow gallium oxide to fully demonstrate its performance as a power semiconductor device, it is desirable to obtain a thin gallium oxide film with an even larger area and a better film thickness distribution, for example, a film thickness of 30 µm or less, and such crystal film has been eagerly anticipated.

To address this problem, Patent Document 10 discloses a method for yielding a gallium oxide film having a favorable film thickness distribution using an ELO mask. However, the method includes complicated steps as it requires a debonding step and a polishing step, and there is a problem that the complicated steps lead to a decrease in yield.

The present invention aims to provide: a film forming method for forming a crystalline oxide film, that has excellent crystallinity and a favorable in-plane film thickness distribution even with a large area and a thin film thickness, and has excellent semiconductor properties when applied to a semiconductor device; and a film forming apparatus for performing the film forming method.

### SOLUTION TO PROBLEM

To solve the above-described problems, the present invention provides a film forming method that sprays mist on a heated substrate from a nozzle to form a crystalline oxide film by a mist CVD method,
wherein the nozzle for use in the method includes at least two or more opposing gas inlets, a gas mixing unit having the gas inlets, and a gas outlet from which the mist is sprayed, and
a linear velocity L (cm/sec) of the mist at any one of the two or more opposing gas inlets satisfies L≥0.8V-200, wherein V (cm³) represents a volume of the gas mixing unit.

Such film forming method is capable of yielding a crystalline oxide film that has excellent crystallinity and a favorable in-plane film thickness distribution even with a thin film thickness. Furthermore, it is capable of yielding a crystalline oxide film having excellent semiconductor properties when applied to a semiconductor device.

In this case, the substrate for use in the method can have a diameter of 100 mm to 200 mm.

The film forming method of the present invention is capable of yielding a crystalline oxide film that has a favorable film thickness distribution even on such large-area substrate.

In this case, the crystalline oxide film can contain gallium oxide as a main component.

Such film forming method is capable of yielding a crystalline oxide film containing gallium oxide as a main component and having a favorable in-plane film thickness distribution even with a thin film thickness.

In this case, the gas mixing unit for use in the film forming method can have the volume V (cm³) satisfying V>250.

Such film forming method is capable of yielding a crystalline oxide film that has a more favorable in-plane film thickness distribution.

The present invention further provides a film forming apparatus, including:
an atomizer configured to generate a mist; a film forming unit configured to form a crystalline oxide film; and a nozzle configured to supply the mist to the film forming unit,
wherein the nozzle includes at least two or more opposing gas inlets, a gas mixing unit having the gas inlets, and a gas outlet from which the mist is sprayed, and
the atomizer and the gas inlets of the gas mixing unit are coupled to each other by piping, the piping further including a portion adjacent to the gas inlets having a smaller inner diameter than an inner diameter of the piping upstream thereof.

Such film forming apparatus is capable of performing the above-described film forming method, and yielding a crystalline oxide film having excellent crystallinity and a favorable in-plane film thickness distribution even with a thin film thickness. Furthermore, it is possible to obtain a crystalline oxide film having excellent semiconductor properties when applied to a semiconductor device.

In this case, in the film forming apparatus, the gas mixing unit can have a volume V (cm³) satisfying V>250.

Such film forming apparatus is capable of yielding a film having a more favorable in-plane film thickness distribution.

The present invention further provides a film forming method that sprays mist on a heated substrate from a nozzle to form a crystalline oxide film by a mist CVD method,
wherein the nozzle for use in the method includes at least two or more opposing gas inlets, a gas mixing unit having the gas inlets, and a gas outlet from which the mist is sprayed, and
a linear velocity of the mist is increased adjacent to the gas inlets.

Such film forming method is capable of yielding a crystalline oxide film having excellent crystallinity and a favorable in-plane film thickness distribution even with a thin film thickness. Furthermore, it is possible to obtain a crystalline oxide film having excellent semiconductor properties when applied to a semiconductor device.

In this case, a linear velocity L (cm/sec) of the mist at any one of the two or more opposing gas inlets can satisfy L≥0.8V-200, wherein V (cm³) represents a volume of the gas mixing unit.

Such film forming method is capable of yielding a crystalline oxide film having a more favorable in-plane film thickness distribution.

In this case, the gas mixing unit for use in the film forming method can have the volume V (cm³) satisfying V>250.

Such film forming method is capable of yielding a crystalline oxide film having a more favorable in-plane film thickness distribution.

In this case, the substrate for use in the method can have a diameter of 100 mm to 200 mm.

The film forming method of the present invention is capable of yielding a crystalline oxide film that has a favorable film thickness distribution even on such large-area substrate.

In this case, the crystalline oxide film can contain gallium oxide as a main component.

Such film forming method is capable of yielding a crystalline oxide film containing gallium oxide as a main component and having a favorable in-plane film thickness distribution even with a thin film thickness.

### ADVANTAGEOUS EFFECTS OF INVENTION

As described above, the inventive film forming method enables to form a crystalline oxide film containing gallium oxide as a main component and having excellent crystallinity and a favorable in-plane film thickness distribution even with a thin film thickness, the crystalline oxide film having excellent semiconductor properties when applied to a semiconductor device. The inventive film forming apparatus is capable of performing the above-described film forming method, and yielding a crystalline oxide film containing gallium oxide as a main component and having excellent crystallinity and a favorable in-plane film thickness distribution even with a thin film thickness. The crystalline oxide film formed in this manner has a favorable film thickness distribution, can fully demonstrate its performance as the crystalline oxide film when applied to a power semiconductor device, and also can reduce performance variation.

### BRIEF DESCRIPTION OF DRAWINGS

FIG. 1 is a diagram illustrating one example of a nozzle usable in the present invention.
FIG. 2 is a diagram illustrating another example of a nozzle usable in the present invention.
FIG. 3 is a schematic illustration of a configuration, illustrating one example of a semiconductor device using a laminate structure according to the present invention.
FIG. 4 is a schematic illustration of a configuration, illustrating one example of a film forming apparatus (mist CVD apparatus) suitably used for deposition of a laminate structure according to the present invention.
FIG. 5 is a diagram illustrating one example of an atomizer used in the present invention.
FIG. 6 is a diagram illustrating one example of a nozzle usable in the present invention, where an area of an opening in the nozzle is 50% or less of an area of a partition wall.
FIG. 7 is a diagram illustrating one example of a nozzle usable in the present invention, where an area of an opening in the nozzle is more than 50% of an area of a partition wall.
FIG. 8 is a diagram illustrating one example of a nozzle usable in the present invention, where there is no partition wall inside the nozzle.

### DESCRIPTION OF EMBODIMENTS

As described above, it has been demanded to provide: a film forming method for forming a crystalline oxide film, that has excellent crystallinity and a favorable in-plane film thickness distribution even with a large area and a thin film thickness, and has excellent semiconductor properties when applied to a semiconductor device; and a film forming apparatus for performing the film forming method.

As a result of an intensive investigation on the above problems, the present inventors have found that a crystalline oxide film having excellent crystallinity and a favorable in-plane film thickness distribution even with a thin film thickness, and having excellent semiconductor properties when applied to a semiconductor device can be obtained by a film forming method that sprays mist on a heated substrate from a nozzle to form a crystalline oxide film by a mist CVD method, wherein the nozzle includes at least two or more opposing gas inlets, a gas mixing unit having the gas inlets, and a gas outlet from which the mist is sprayed, and a linear velocity L (cm/sec) of the mist at any one of the two or more gas inlets satisfies L≥0.8V-200, wherein V (cm³) represents a volume of the gas mixing unit, and completed the present invention.

Furthermore, the present inventors have found that a crystalline oxide film having excellent crystallinity and a favorable in-plane film thickness distribution even with a thin film thickness can be obtained by a film forming apparatus including: a nozzle including at least two or more opposing gas inlets, a gas mixing unit having the gas inlets, and a gas outlet from which a mist is sprayed; a film forming unit; and an atomizer configured to generate a mist, wherein the atomizer and the gas inlets of the gas mixing unit are coupled to each other by piping, the piping further including a portion adjacent to the gas inlets having a smaller inner diameter than an inner diameter of the piping upstream thereof, and completed the present invention.

Furthermore, the present inventors have found that a crystalline oxide film having excellent crystallinity and a favorable in-plane film thickness distribution even with a thin film thickness, and having excellent semiconductor properties when applied to a semiconductor device can be obtained by a film forming method that sprays mist on a heated substrate from a nozzle to form a crystalline oxide film by a mist CVD method, wherein the nozzle includes at least two or more opposing gas inlets, a gas mixing unit having the gas inlets, and a gas outlet from which the mist is sprayed, and a linear velocity of the mist is increased adjacent to the gas inlets, and completed the present invention.

Thus, the present invention is a film forming method that sprays mist on a heated substrate from a nozzle to form a crystalline oxide film by a mist CVD method,
wherein the nozzle for use in the method includes at least two or more opposing gas inlets, a gas mixing unit having the gas inlets, and a gas outlet from which the mist is sprayed, and
a linear velocity L (cm/sec) of the mist at any one of the two or more opposing gas inlets satisfies L≥0.8V-200, wherein V (cm³) represents a volume of the gas mixing unit.

Additionally, the present invention is a film forming apparatus, including:
an atomizer configured to generate a mist; a film forming unit configured to form a crystalline oxide film; and a nozzle configured to supply the mist to the film forming unit,
wherein the nozzle includes at least two or more opposing gas inlets, a gas mixing unit having the gas inlets, and a gas outlet from which the mist is sprayed, and
the atomizer and the gas inlets of the gas mixing unit are coupled to each other by piping, the piping further including a portion adjacent to the gas inlets having a smaller inner diameter than an inner diameter of the piping upstream thereof.

Furthermore, the present invention is a film forming method that sprays mist on a heated substrate from a nozzle to form a crystalline oxide film by a mist CVD method,
wherein the nozzle for use in the method includes at least two or more opposing gas inlets, a gas mixing unit having the gas inlets, and a gas outlet from which the mist is sprayed, and
a linear velocity of the mist is increased adjacent to the gas inlets.

Hereinafter, the present invention will be described in detail. However, the present invention is not limited thereto.

### (Crystalline Oxide Film)

The crystalline oxide film according to the present invention has a favorable film thickness distribution. The film thickness distribution can be considered to be favorable when, for example, a value calculated by ((maximum film thickness - minimum film thickness)/(maximum film thickness + minimum film thickness))×100 (%) for the film thickness at 25 points in the plane is 10% or less. It is further preferably 5% or less. Such crystalline oxide film according to the present invention can fully demonstrate performance of the crystalline oxide film when applied to a power semiconductor device, and also reduce performance variation.

Generally, a crystalline oxide film is composed of metal and oxygen, but the crystalline oxide film according to the present invention preferably contains gallium as the metal as a main component. Note that in the present invention, the phrase "contain gallium oxide as a main component" means that 50 to 100% of the metal component is gallium. As the metal component other than gallium, for example, one or two or more metals selected from iron, indium, aluminum, vanadium, titanium, chromium, rhodium, iridium, nickel, and cobalt may be contained.

The crystalline oxide film may contain dopant elements. Examples thereof include, but are not particularly limited to, n-type dopants such as tin, germanium, silicon, titanium, zirconium, vanadium, or niobium, or p-type dopants such as copper, silver, tin, iridium, rhodium, or magnesium, etc. A concentration of the dopant may be, for example, about 1×10¹⁶/cm³ to 1×10²²/cm³, or may be a low concentration of about 1×10¹⁷/cm³ or less, or a high concentration of about 1×10²⁰/cm³ or more.

A crystal structure of the crystalline oxide film is not particularly limited, and may be a β-gallia structure, a corundum structure, or an orthorhombic crystal. It may be a mixture of a plurality of crystal structures or polycrystalline, but preferred is a single crystal or a uniaxially oriented film. Whether the film is a single crystal or uniaxially oriented can be confirmed by an X-ray diffraction apparatus, an electron diffraction apparatus, or the like. When the film is irradiated with X-rays or electron beams, a diffraction image according to the crystal structure can be obtained. If the film is uniaxially oriented, only a specific peak appears. Accordingly, it can be determined as uniaxially oriented.

Although a film thickness of the crystalline oxide film is not particularly limited, it is preferably 0.1 µm or more. The upper limit is not particularly limited. For example, it may be 100 µm or less, preferably 50 µm or less, and more preferably 30 µm or less. The film thickness can be measured by any of methods using a stylus profiler, a film thickness measurement system based on reflective spectroscopy, an ellipsometer, observation of the cross section with SEM or TEM, etc.

Such crystalline oxide film can be formed by a mist CVD method using a mist CVD apparatus (film forming apparatus) as described later.

### (Substrate)

A substrate (underlayer substrate) for forming the crystalline oxide film according to the present invention is not particularly limited as long as it can serve as a support for the crystalline oxide film described above. The material thereof is not particularly limited, and a known substrate can be used, which may be an organic compound or an inorganic compound. Examples thereof include polysulfone, polyether sulfone, polyphenylene sulfide, polyetheretherketone, polyimide, polyetherimide, fluororesin, metals such as iron, aluminum, stainless steel, and gold, quartz, glass, calcium carbonate, gallium oxide, ZnO, and the like. In addition to these, the examples also include single crystal substrates such as silicon, sapphire, lithium tantalate, lithium niobate, SiC, GaN, iron oxide, and chromium oxide. In the present invention, the single crystal substrates as described above are preferred. These enables to obtain a crystalline oxide film with better quality. In particular, sapphire substrates, lithium tantalate substrates, and lithium niobate substrates are relatively inexpensive and therefore industrially advantageous.

A thickness of the underlayer substrate is preferably 100 to 5000 µm. The thickness within this range allows easy handling and suppression of thermal resistance during film formation, such that a film with good quality can more easily be obtained.

Although a size of the substrate is not particularly limited, the substrate preferably has an area of 100 mm² or more or a diameter of 2 inches (50 mm) or more, such that a large-area film having excellent crystallinity can be obtained. Further, when the substrate has the diameter of 4 inches (100 mm) to 8 inches (200 mm), the resulting crystalline oxide film can be easily processed by using an existing processing apparatus, which is industrially advantageous upon producing a semiconductor device. Additionally, the crystalline oxide film has the large area and an excellent film thickness distribution, and demonstrates excellent semiconductor properties when applied to a semiconductor device. For example, when a semiconductor device such as a power semiconductor device is produced by using such crystalline oxide film, a product lot including two or more of the semiconductor devices can have a breakdown voltage yield of 75% or more.

Another layer may be interposed between the substrate and the crystalline oxide film. Another layer is a layer having a different composition from those of the substrate and the crystalline oxide film on the top surface. Another layer is also referred to as a buffer layer. The buffer layer may be any of an oxide semiconductor film, an insulating film, a metal film, and the like, and materials such as, for example, Al₂O₃, Ga₂O₃, Cr₂O₃, Fe₂O₃, In₂O₃, Rh₂O₃, V₂O₃, Ti₂O₃, and Ir₂O₃, are suitably used. The buffer layer has a thickness of preferably 0.1 µm to 2 µm.

### (Example Configuration of Semiconductor Device)

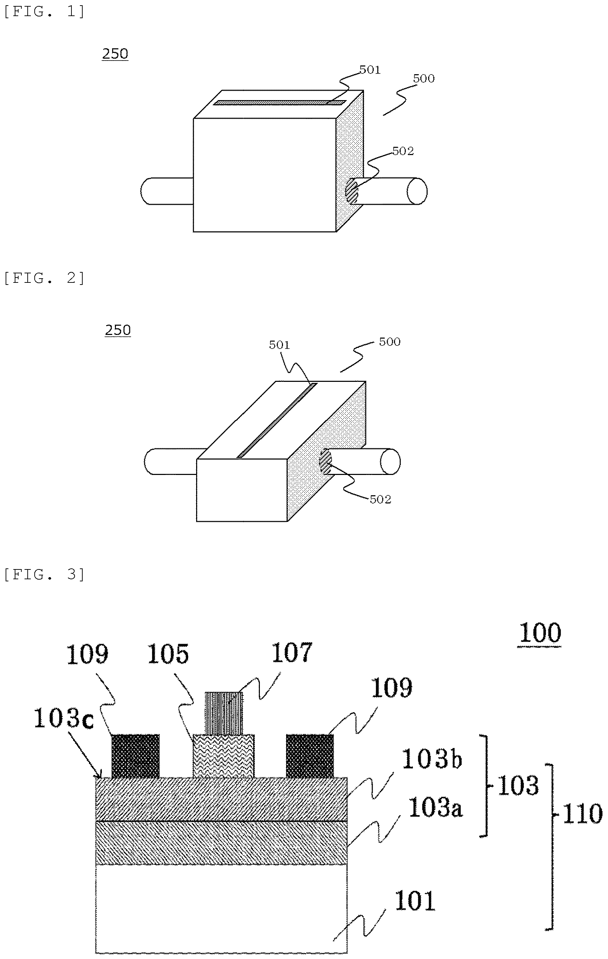

FIG. 3 illustrates a suitable example of a semiconductor device 100 using the crystalline oxide film according to the present invention. In the example of FIG. 3, a laminate structure 110 is formed with a crystalline oxide film 103 formed on a substrate 101. The crystalline oxide film 103 is configured with an insulating thin film 103a and a conductive thin film 103b laminated in this order from the side of the substrate 101. On a surface 103c of the conductive thin film 103b, a gate insulating film 105 is formed. On the gate insulating film 105, a gate electrode 107 is formed. Furthermore, on the surface 103c of the conductive thin film 103b, source/drain electrodes 109 are formed to sandwich the gate electrode 107. This configuration enables to control a depletion layer formed in the conductive thin film 103b by gate voltage applied to the gate electrode 107, thereby enabling a transistor operation (FET device). Examples of the semiconductor device formed using the laminate structure according to the present invention include transistors such as MIS, HEMT, and IGBT, TFT, Schottky Barrier Diodes using a semiconductor-metal junction, PN or PIN diodes in combination with other P-layers, and light receiving/emitting elements. The laminate structure according to the present invention is useful for enhancing properties of these devices.

Hereinafter, a film forming apparatus and a film forming method for forming the crystalline oxide film according to the present invention by a mist CVD method will be described. Here, the mist in the present invention refers to a general term for fine particles of a liquid dispersed in a gas, including those called mist, droplets, etc.

### (Film Forming Apparatus)

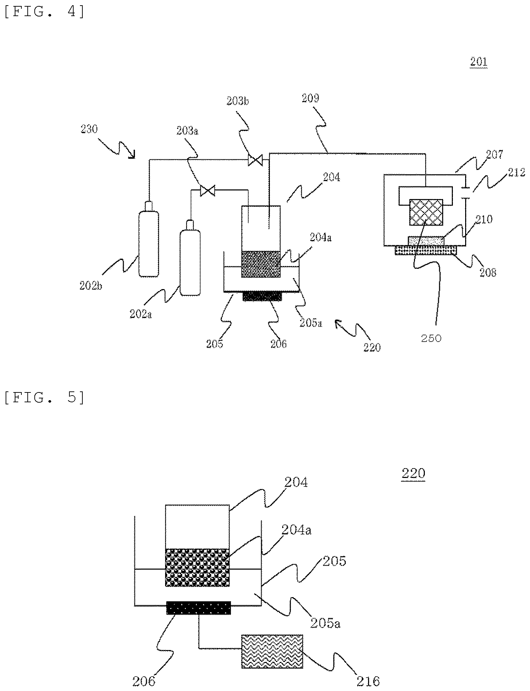

FIG. 4 is a schematic illustration of a film forming apparatus 201 that forms a film by a mist CVD method. The film forming apparatus 201 includes at least: an atomizer 220 configured to atomize a raw material solution 204a into a mist to generate the mist; a carrier gas supply unit 230 configured to supply a carrier gas for transferring the mist; a supply pipe 209 connecting between the atomizer 220 and a deposition chamber 207, through which the mist is transferred by the carrier gas; the deposition chamber 207 in which the mist is subjected to heat treatment to form a film on a substrate 210; and a nozzle 250 configured to spray the mist supplied from the supply pipe 209 together with the carrier gas on the substrate. Additionally, a top plate or the like for rectifying the supplied mist on the substrate may be provided.

### (Atomizer)

In the atomizer 220, the raw material solution 204a is atomized into a mist, thereby generating the mist. A mist-forming means is not particularly limited as long as it is capable of atomizing the raw material solution 204a into a mist, and may be a known mist-forming means. Preferably, a mist-forming means by way of ultrasonic vibration is used. This is because of its ability to stably form a mist.

FIG. 5 illustrates one example of such atomizer 220. The atomizer 220 may include: a mist source 204 in which the raw material solution 204a is stored; a container 205 that contains a medium capable of transmitting ultrasonic vibration, for example, water 205a; and an ultrasonic vibrator 206 attached to the bottom surface of the container 205. In detail, the mist source 204 including a container in which the raw material solution 204a is stored can be housed in the container 205 that contains the water 205a using a support (not shown). At the bottom of the container 205, the ultrasonic vibrator 206 may be installed, and the ultrasonic vibrator 206 and an oscillator 216 may be coupled to each other. Then, it is possible to configure such that when the oscillator 216 is operated, the ultrasonic vibrator 206 vibrates to propagate ultrasonic waves into the mist source 204 through the water 205a, thereby atomizing the raw material solution 204a into a mist.

### (Raw Material Solution)

The material contained in the raw material solution 204a is not particularly limited as long as it can be atomized into a mist. It may be an inorganic material or an organic material. Metals or metal compounds are suitably used as the material. For example, those containing one or two or more metals selected from gallium, iron, indium, aluminum, vanadium, titanium, chromium, rhodium, nickel, and cobalt may be used. As the raw material solution described above, those obtained by dissolving or dispersing a metal in an organic solvent or water in a form of a complex or a salt can be suitably used. Examples of the form of the salt include halide salts such as metal chloride salt, metal bromide salt, and metal iodide salt. Further, a solution obtained by dissolving the above metal in hydrogen halide such as hydrobromic acid, hydrochloric acid, and hydriodic acid can also be used as a salt solution. Examples of the form of the complex include an acetylacetonate complex, a carbonyl complex, an ammine complex, a hydride complex, and the like. The acetylacetonate complex can also be formed by mixing acetylacetone with the above salt solution. A metal concentration in the raw material solution 204a is not particularly limited and can be 0.005 to 1 mol/L, etc. Temperature during mixing and dissolving is preferably 20°C or higher.

Additives such as hydrogen halide acid or an oxidizing agent may be mixed with the raw material solution. Examples of the hydrogen halide acid include hydrobromic acid, hydrochloric acid, and hydriodic acid, among which hydrobromic acid or hydriodic acid is preferred. Examples of the oxidizing agent include: peroxides such as hydrogen peroxide (H₂O₂), sodium peroxide (Na₂O₂), barium peroxide (BaO₂), and benzoyl peroxide (C₆H₅CO)₂O₂; hypochlorous acid (HClO), perchloric acid, nitric acid, ozonized water, and organic peroxides such as peracetic acid, and nitrobenzene, and the like.

The raw material solution may contain a dopant. The dopant is not particularly limited. Examples thereof include: n-type dopants such as tin, germanium, silicon, titanium, zirconium, vanadium, or niobium, and the like; p-type dopants such as copper, silver, tin, iridium, rhodium, or magnesium, and the like.

### (Carrier Gas Supply Unit)

As shown in FIG. 4, the carrier gas supply unit 230 has a carrier gas source 202a configured to supply a carrier gas. In this case, a flow control valve 203a for adjusting a flow rate of the carrier gas delivered from the carrier gas source 202a may be provided. Additionally, a dilution carrier gas source 202b configured to supply a carrier gas for dilution, and a flow control valve 203b for adjusting a flow rate of the carrier gas for dilution delivered from the dilution carrier gas source 202b can also be provided as necessary. Note that in the present invention, the sum of the flow rates of the carrier gas and the carrier gas for dilution is referred to as the total carrier gas flow rate.

A type of the carrier gas is not particularly limited, and can be selected as appropriate depending on the film to be formed. Examples thereof include oxygen, ozone, an inert gas such as nitrogen or argon, a reducing gas such as hydrogen gas or forming gas, and the like. Further, one type or two or more types of the carrier gas may be used. For example, a diluted gas (for example, 10-fold dilution) obtained by diluting the same gas as a first carrier gas with another gas may further be used as a second carrier gas, or air is also usable. The total carrier gas flow rate is not particularly limited. For example, when a film is formed on a substrate having a diameter of 2 inches (about 50 mm), the total carrier gas flow rate is preferably 0.05 to 50 L/min, more preferably 5 to 20 L/min.

### (Supply Pipe)

The film forming apparatus 201 has the supply pipe 209 connecting between the atomizer 220 and the deposition chamber 207. In this case, the mist is transferred from the mist source 204 of the atomizer 220 through the supply pipe 209 by the carrier gas, and supplied into the deposition chamber 207. As the supply pipe 209, for example, a quartz tube, a glass tube, a resin tube, or the like can be used.

### (Deposition Chamber)

An example of the film forming unit included in the film forming apparatus of the present invention is the deposition chamber 207. The substrate 210 is placed inside the deposition chamber 207, where a heater 208 for heating the substrate 210 can be disposed. The heater 208 may be disposed, as shown in FIG. **4****,** outside the deposition chamber 207, or inside the deposition chamber 207. The mist supplied from the supply pipe 209 passes through piping inside the deposition chamber 207, and is splayed together with the carrier gas from the nozzle 250 toward the substrate 210.

The film forming apparatus according to the present invention includes: the nozzle 250 including at least two or more opposing gas inlets, a gas mixing unit having the gas inlets, and a gas outlet from which the mist is sprayed; and a portion of the piping adjacent to the gas inlets having a smaller inner diameter than an inner diameter of the piping upstream thereof. One example of the nozzle having the opposing gas inlets are illustrated in FIGs. 1 and 2.

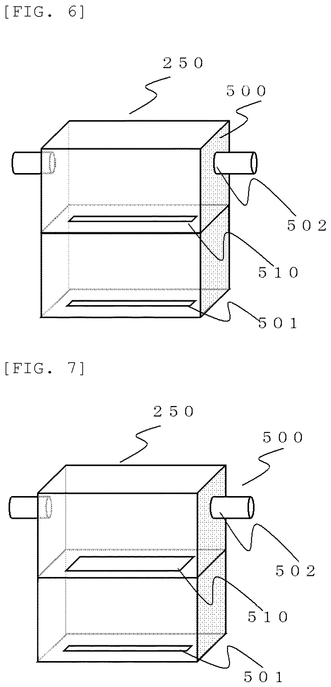

Generally, a nozzle has a gas inlet and a gas outlet, which are spatially continuous to each other. In the present application, the nozzle 250 may be separated into a space including gas inlets 502 and a space including a gas outlet 501 by a partition wall or the like provided with an opening. In this case, when an area of the opening is 50% or less of an area of the partition wall, the space including the gas inlets 502 can serve as a gas mixing unit 500, while the space including the gas outlet 501 can serve as a gas discharge unit. FIG. 6 illustrates one example where the area of an opening 510 in the nozzle is 50% or less of the area of the partition wall (including the opening). The gas mixing unit 500 serves a function of retaining a gas coming in from the gas inlets 502, stirring the gas, and sending the gas to the gas discharge unit.

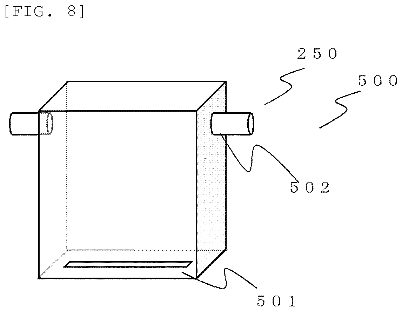

On the other hand, when the area of the opening is more than 50% of the area of the partition wall, or when there is no partition wall, the nozzle 250 as a whole is regarded as the gas mixing unit 500. FIG. 7 illustrates one example where the area of the opening exceeds 50%, and FIG. 8 illustrates an example with no partition wall. In the present invention, the nozzle 250 as a whole is regarded as the gas mixing unit 500 in both of FIGs. 7 and 8.

A shape of the gas outlet 501 is not limited, and may be a slit as shown in the drawings, a square, or a round shape. In the present invention, there are two or more gas inlets 502, and further the gas inlets 502 face each other. The piping is usually coupled to the gas inlets. If normal lines extending from the center (or the center of gravity if the shape is not round) of the piping to the two gas inlets approximately coincide with each other, the gas inlets of the nozzle can be deemed to face each other.

An inner diameter of the piping is generally 10 to 80 mm, but not limited thereto. In the present invention, the piping has a portion adjacent to the gas inlets having a smaller inner diameter than an inner diameter of the piping upstream thereof. For example, if the piping has the inner diameter of 10 mm, an orifice with an opening of about 1 to 9 mm may be installed inside the piping, or the inner diameter of the piping may be reduced using a deformed reducer or the like. The portion adjacent to the gas inlet refers to a portion approximately 0 to 10 cm from the gas inlet. The portion of the piping having the smaller inner diameter than the inner diameter of the piping upstream thereof is installed adjacent to the respective gas inlets.

A linear velocity of the gas can be increased by reducing the inner diameter of the piping, and further the mist can be homogenously distributed inside the nozzle because the gas inlets 502 face each other. This results in a uniform density of the mist sprayed from the nozzle (gas outlet 501), and thus the uniform thickness of the film to be obtained. Furthermore, a volume V (cm³) of the gas mixing unit 500 inside the nozzle preferably satisfies V>250. This enables to more homogeneously distribute the mist inside the nozzle, thereby obtaining a uniform film thickness.

The distance between the opposing gas inlets is not particularly limited. However, if the distance is too short, the mist is poorly distributed to deteriorate the film thickness distribution. Accordingly, the distance is preferably equal to or greater than the diameter of the substrate.

The deposition chamber 207 may be provided with an exhaust port 212 for an exhaust gas at a position that does not affect the supply of the mist to the substrate 210. Furthermore, face-down such as placing the substrate 210 on a top surface of the deposition chamber 207 or face-up such as placing the substrate 210 on a bottom surface of the deposition chamber 207 may be applied.

A substrate mounted section or the nozzle may be coupled to a transfer mechanism, thereby enabling motion such as reciprocating or rotational motion. By performing these motion operations during film formation, uniformity of the film to be obtained will be further enhanced.

The material of the nozzle 250 preferably has high heat resistance and physical strength. Specific examples thereof include metals and ceramics. More specifically, suitably used are iron, aluminum, titanium, magnesium, nickel, copper, and alloys thereof; silicon oxide, aluminum oxide, zirconium oxide, titanium oxide, silicon carbide, silicon nitride, and a solid solution thereof; and the like. Furthermore, since temperature inside the nozzle 250 is relatively low as compared with the outer surface, at least a part of the inside of the nozzle 250 may be lined or coated with a resin or ceramics from the viewpoint of corrosion resistance. Specifically, any of the followings can be suitably used: polyethylene, polypropylene, vinyl chloride, polystyrene, polyvinyl acetate, urethane resin, fluororesin, acrylonitrile-butadiene-styrene resin, acrylic resin, polyamide, polyimide, polyamideimide, nylon, acetal resin, polycarbonate, polyphenylene ether, polyester, polyethylene terephthalate, polybutylene terephthalate, polyolefin, polyphenylene sulfide, polysulfone, polyethersulfone, polyarylate, polyetheretherketone, acrylic rubber, isoprene rubber, urethane rubber, ethylene propylene rubber, ethylene vinyl acetate rubber, chloroprene rubber, styrene rubber, nitrile rubber, fluoro rubber, butadiene rubber, butyl rubber, aluminum oxide, aluminum nitride, silicon oxide, silicon nitride, and silicon carbide.

Furthermore, a shape of the nozzle is not limited to a rectangular parallelepiped as illustrated in FIGs. 1 and 2, and may be cylindrical or conical, or a complex shape such as a mixture thereof. As described above, the shape of the nozzle is not limited as long as it includes at least two or more opposing gas inlets, the gas mixing unit having the gas inlets, and the gas outlet from which the mist is sprayed.

### (Film Forming Method)

The mist CVD method includes: a mist generation step of atomizing a raw material solution containing gallium into a mist, thereby generating the mist in an atomizer; a carrier gas supply step of supplying a carrier gas for transferring the mist to the atomizer; a transfer step of transferring the mist from the atomizer to a deposition chamber through a supply pipe connecting between the atomizer and the deposition chamber by using the carrier gas; and a film forming step of subjecting the transferred mist to heat treatment, thereby forming a film on an underlayer substrate.

The raw material solution 204a prepared as described above is stored in the mist source 204, the substrate 210 is placed inside the deposition chamber 207, and the heater 208 is operated. Next, the flow control valves 203a, 203b are opened to supply the carrier gases from the carrier gas sources 202a, 202b into the deposition chamber 207. After sufficiently replacing the atmosphere in the deposition chamber 207 with the carrier gases, the flow rate of the carrier gas and the flow rate of the carrier gas for dilution are respectively adjusted.

Next, as the mist generation step, the ultrasonic vibrator 206 is vibrated to propagate its vibration to the raw material solution 204a through the water 205a to atomize the raw material solution 204a into a mist, thereby generating the mist.

Next, as the carrier gas supply step, the carrier gas for transferring the mist is supplied to the atomizer 220.

Next, as the transfer step, through the supply pipe 209 connecting between the atomizer 220 and the deposition chamber 207, the mist is transferred by the carrier gas from the atomizer 220 to the nozzle in the deposition chamber 207.

Next, as the film forming step, the mist transferred to the nozzle is sprayed on the substrate, and thermal reaction is caused by heating to form a film on the surface of the substrate 210. In the present invention, a linear velocity L (cm/sec) of the mist at any one of the gas inlets 502 satisfies L≥0.8V-200, wherein V (cm³) represents a volume of the gas mixing unit 500 in the nozzle. Because of the opposing gas inlets 502 and the great linear velocity of the mist, it is possible to homogenously distribute the mist in the nozzle 250. This results in the uniform density of the mist sprayed from the nozzle, and thus the uniform thickness of the film to be obtained. The upper limit of the linear velocity L is not particularly limited, and can be, for example, 3,000 cm/sec or less. Furthermore, the volume V (cm³) of the gas mixing unit 500 in the nozzle preferably satisfies V>250. This enables to more homogenously distribute the mist in the nozzle, resulting in the uniform thickness of the film to be obtained. As V becomes significantly large, the necessary linear velocity also becomes large, and thus it is necessary to reduce the inner diameter of the piping. However, when the inner diameter is too small, the mist collides with the orifice or the piping wall and disappears, resulting in the reduced deposition rate. Accordingly, V is preferably equal to or less than 2000.

Note that the linear velocity L can be determined as L=Q/S×1000/60, wherein S (cm²) represents a cross-sectional area of a portion of the piping having the narrowest inner diameter, and Q (L/min) represents a flow rate of a gas flowing through this portion. The gas flow rate Q can be a value under standard conditions (0°C, 1 atm). When there are two gas inlets 502 and the shapes of the piping coupled thereto are approximately the same, the gas flow rate Q of one gas inlet 502 is estimated to be 1/2 of the total carrier gas flow rate. Even when the shapes of the piping are different from each other, the flow rate at each inlet can be estimated by calculating a pressure loss by a general method, and the resulting estimated value can be regarded as the total carrier gas flow rate flowing through the piping.

The substrate or the nozzle may be coupled to a transfer mechanism, thereby performing motion such as reciprocating or rotational motion during film formation. By performing these motion operations, uniformity of the film to be obtained will be further enhanced.

For the thermal reaction of the mist, reaction of gallium and other elements contained in the mist should be promoted by heating, but unlike other CVD methods, the mist CVD method requires the raw material to reach the substrate surface in a mist form of an atomized liquid. This causes great decrease in the temperature of the substrate surface. Therefore, the temperature of the substrate surface during the reaction is different from the temperature set in the apparatus. It is preferable to measure and control the temperature of the substrate surface even during the reaction, but if this is difficult, alternatively, it is possible to simulate the reaction and measure the temperature by introducing only the carrier gas or introducing a water mist containing no solute.

Furthermore, the thermal reaction also depends on temperature of the environment around the substrate. Accordingly, temperature of the nozzle or the inner wall of the deposition chamber is preferably higher than a room temperature. This is because the above thermal reaction can be stabilized. For example, the temperature of the nozzle can be 50 to 250°C.

Note that the thermal reaction may be carried out under any of vacuum, non-oxygen atmosphere, reducing gas atmosphere, air atmosphere, and oxygen atmosphere, that may be appropriately set according to the film to be formed. Furthermore, the reaction pressure may be under any of conditions including atmospheric pressure, increased pressure, and reduced pressure, but film formation under atmospheric pressure is preferred because it enables simplification of the apparatus configuration.

### (Formation of Buffer Layer)

As described above, the buffer layer may be provided between the substrate and the crystalline oxide film as appropriate. A method for forming the buffer layer is not particularly limited, and a known method such as sputtering and vapor deposition methods can be used to form the buffer layer. However, when using the mist CVD method as described above, it is possible to simply and easily form the buffer layer by only changing the raw material solution as appropriate. Specifically, one or two or more metals selected from aluminum, gallium, chromium, iron, indium, rhodium, vanadium, titanium, and iridium is dissolved or dispersed in water in a form of a complex or a salt, and the resultant can suitably be used as an aqueous solution of the raw material. Examples of the form of the complex include an acetylacetonate complex, a carbonyl complex, an ammine complex, a hydride complex, and the like. Examples of the form of the salt include metal chloride salt, metal bromide salt, metal iodide salt, and the like. Further, a solution obtained by dissolving the above metal in hydrobromic acid, hydrochloric acid, hydriodic acid, or the like can also be used as an aqueous solution of the salt. Also in this case, the solute concentration is preferably 0.005 to 1 mol/L, and the dissolution temperature is preferably 20°C or higher. The other conditions can also be the same as described above, thereby allowing the formation of the buffer layer. After the buffer layer is formed to have a predetermined thickness, the crystalline oxide film is formed by the above-described method.

As a special case of the method for forming the buffer layer, the same material as for the crystalline oxide film is used. In this case, deposition temperature of the buffer layer may be higher than the deposition temperature of the crystalline oxide film. For example, the deposition temperature of the buffer layer may be 450°C whereas the deposition temperature of the crystalline oxide film may be 400°C, or the deposition temperature of the buffer layer may be 500°C whereas the deposition temperature of the crystalline oxide film may be 450°C, etc. This can further enhance crystallinity of the crystalline oxide film.

### (Heat Treatment)

The laminate structure according to the present invention may be subjected to heat treatment at 200 to 600°C. This can further remove unreacted species, etc. in the film, thereby yielding the laminate structure with higher quality. The heat treatment may be performed in the air, oxygen atmosphere, or inert gas atmosphere such as nitrogen or argon. The duration of the heat treatment can be determined as appropriate, and can be, for example, 5 to 240 minutes.

### (Debonding)

In the laminate structure according to the present invention, the crystalline oxide film may be debonded from the underlayer substrate. A debonding means is not particularly limited and may be a known means. Examples of the debonding means include debonding by: applying mechanical shock; applying heat and using thermal stress; applying vibration such as ultrasonic waves; etching; etc. By debonding in this manner, it is possible to obtain the crystalline oxide film as a freestanding film.

### EXAMPLE

Hereinafter, the present invention will be specifically described with reference to Examples and Comparative Examples. However, the present invention is not limited thereto.

### Example 1: V=290, with Orifice

In the present example, the film forming apparatus 201 illustrated in FIG. 4 was used. The film forming apparatus 201 includes: the carrier gas source 202a configured to supply a carrier gas; the flow control valve 203a for adjusting a flow rate of the carrier gas delivered from the carrier gas source 202a; the dilution carrier gas source 202b configured to supply a carrier gas for dilution; the flow control valve 203b for adjusting a flow rate of the carrier gas for dilution delivered from the dilution carrier gas source 202b; the mist source 204 in which the raw material solution 204a is stored; the container 205 that contains the water 205a; the ultrasonic vibrator 206 attached to the bottom surface of the container 205; the deposition chamber 207 equipped with the heater 208; and the supply pipe 209 made of quartz, connecting between the mist source 204 and the deposition chamber 207.

Inside the deposition chamber 207, there is the nozzle 250 with the opposing gas inlets, and the supply pipe 209 extends and is coupled to the nozzle by the piping having an inner diameter of 20 mm. Furthermore, an orifice with an opening diameter of 7 mm is provided in the piping 2 cm away from the gas inlets. Since the volume of the gas mixing unit 500 in the nozzle is 290 cm³, 0.8V-200 is 32 cm/sec.

### (Formation of Gallium Oxide Film)

Then, a gallium oxide film was formed. As the substrate 210, a 4-inch (100 mm) c-plane sapphire substrate was prepared. This substrate was placed inside the deposition chamber 207, and the heater 208 was set at the temperature of 450°C. The temperature was raised and then left as it was for 30 minutes, thereby stabilizing the temperature inside the deposition chamber including the nozzle.

For the raw material solution 204a, ultrapure water was used as a solvent, and gallium bromide was used as a solute. The concentration of gallium in the raw material solution was 0.1 mol/L. This raw material solution 204a was stored in the mist source 204. Then, the flow control valves 203a, 203b were opened to supply the carrier gases from the carrier gas sources 202a, 202b into the deposition chamber 207. After sufficiently replacing the atmosphere in the deposition chamber 207 with the carrier gases, the flow rate of the carrier gas was adjusted to 4 L/min and the flow rate of the carrier gas for dilution was adjusted to 6 L/min, respectively. Accordingly, the total carrier gas flow rate was 10 L/min, and a linear velocity at the time of passing through the orifice was 217 cm/sec. Nitrogen was used as the carrier gases.

Next, the ultrasonic vibrator 206 was vibrated at 2.4 MHz, and the vibration thereof was propagated to the raw material solution 204a through the water 205a, thereby atomizing the raw material solution 204a into a mist to generate the mist. This mist was introduced into the deposition chamber 207 through the supply pipe 209 by the carrier gas, and thermal reaction of the mist was carried out on the substrate 210 to form a thin film of gallium oxide on the substrate 210. The duration of the film formation was 30 minutes.

### (Evaluation)

Regarding the thin film formed on the substrate 210, formation of α-Ga₂O₃ was confirmed by X-ray diffraction. The rocking curve of a (006) surface of the α-Ga₂O₃ was measured, and the half-width thereof was 6 seconds, indicating extremely good crystallinity. Note that upon measuring the rocking curve, a four-crystal monochromator that combines two channel-cut crystals was used to increase monochromaticity of X-rays to allow more accurate measurement. Next, the film thickness was measured at 25 points using F50, a film thickness measurement system based on reflective spectroscopy available from Filmetrics, INC. The average film thickness was 583 nm. Further, the film thickness variation determined by ((maximum film thickness - minimum film thickness)/(maximum film thickness + minimum film thickness))×100 (%) was 3.8%, indicating favorable film thickness variation.

### Comparative Example 1: V=290, No Orifice

Film formation and evaluation were performed by applying the same conditions and method as in Example 1, except that the orifice was not provided in the piping in Example 1. The linear velocity at the inlet of the nozzle was 27 cm/sec. This resulted in a deteriorated average film thickness of 611 nm and film thickness variation of 13.6%.

### Example 2: V=380, with Orifice

Film formation and evaluation were performed by applying the same conditions and method as in Example 1, except that a nozzle having a volume of the gas mixing unit inside the nozzle of 380 cm³ was used in Example 1. As in Example 1, the linear velocity at the time of passing through the orifice was 217 cm/sec. 0.8V-200 was 104 cm/sec. This resulted in a favorable average film thickness of 574 nm and film thickness variation of 2.9%.

### Example 3: V=700, with Orifice

In Example 1, a nozzle having a volume of an inner space of 700 cm³ was used, the flow rate of the carrier gas was 11 L/min, and the flow rate of the carrier gas for dilution was 7 L/min. Except these, film formation and evaluation were performed by applying the same conditions and method as in Example 1. The linear velocity at the inlet of the nozzle was 390 cm/sec, and 0.8V-200 was 360 cm/sec. This resulted in a favorable average film thickness of 1134 nm and film thickness variation of 3.2%.

### Comparative Example 2: V=700, No Orifice

Film formation and evaluation were performed by applying the same conditions and method as in Example 3, except that the orifice was not provided in the piping in Example 3. The linear velocity at the inlet of the nozzle was 48 cm/sec. This resulted in a deteriorated average film thickness of 1180 nm and film thickness variation of 12.5%.

The present description includes the following embodiments.
[1]: A film forming method that sprays mist on a heated substrate from a nozzle to form a crystalline oxide film by a mist CVD method,
   wherein the nozzle for use in the method comprises at least two or more opposing gas inlets, a gas mixing unit comprising the gas inlets, and a gas outlet from which the mist is sprayed, and
   a linear velocity L (cm/sec) of the mist at any one of the two or more opposing gas inlets satisfies L≥0.8V-200, wherein V (cm³) represents a volume of the gas mixing unit.
[2]: The film forming method according to the above [1], wherein the substrate for use in the method has a diameter of 100 mm to 200 mm.
[3]: The film forming method according to the above [1] or [2], wherein the crystalline oxide film comprises gallium oxide as a main component.
[4]: The film forming method according to the above [1], [2], or [3], wherein the gas mixing unit for use in the method has the volume V (cm³) satisfying V>250.
[5]: A film forming apparatus, comprising:
   an atomizer configured to generate a mist; a film forming unit configured to form a crystalline oxide film; and a nozzle configured to supply the mist to the film forming unit,
   wherein the nozzle comprises at least two or more opposing gas inlets, a gas mixing unit comprising the gas inlets, and a gas outlet from which the mist is sprayed, and
   the atomizer and the gas inlets of the gas mixing unit are coupled to each other by piping, the piping further comprising a portion adjacent to the gas inlets having a smaller inner diameter than an inner diameter of the piping upstream thereof.
[6]: The film forming apparatus according to the above [5], wherein the gas mixing unit has a volume V (cm³) satisfying V>250.
[7]: A film forming method that sprays mist on a heated substrate from a nozzle to form a crystalline oxide film by a mist CVD method,
   wherein the nozzle for use in the method comprises at least two or more opposing gas inlets, a gas mixing unit comprising the gas inlets, and a gas outlet from which the mist is sprayed, and
   a linear velocity of the mist is increased adjacent to the gas inlets.
[8]: The film forming method according to the above [7], wherein a linear velocity L (cm/sec) of the mist at any one of the two or more opposing gas inlets satisfies L≥0.8V-200, wherein V (cm³) represents a volume of the gas mixing unit.
[9]: The film forming method according to the above [8], wherein the gas mixing unit for use in the method has the volume V (cm³) satisfying V>250.
[10]: The film forming method according to the above [7], [8], or [9], wherein the substrate for use in the method has a diameter of 100 mm to 200 mm.
[11]: The film forming method according to the above [7], [8], [9], or [10], wherein the crystalline oxide film comprises gallium oxide as a main component.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A film forming method that sprays mist on a heated substrate from a nozzle to form a crystalline oxide film by a mist CVD method,
wherein the nozzle for use in the method comprises at least two or more opposing gas inlets, a gas mixing unit comprising the gas inlets, and a gas outlet from which the mist is sprayed, and
a linear velocity L (cm/sec) of the mist at any one of the two or more opposing gas inlets satisfies L≥0.8V-200, wherein V (cm³) represents a volume of the gas mixing unit.

2. The film forming method according to claim 1, wherein the substrate for use in the method has a diameter of 100 mm to 200 mm.

3. The film forming method according to claim 1, wherein the crystalline oxide film comprises gallium oxide as a main component.

4. The film forming method according to claim 2, wherein the crystalline oxide film comprises gallium oxide as a main component.

5. The film forming method according to any one of claims 1 to 4, wherein the gas mixing unit for use in the method has the volume V (cm³) satisfying V>250.

6. A film forming apparatus, comprising:
an atomizer configured to generate a mist; a film forming unit configured to form a crystalline oxide film; and a nozzle configured to supply the mist to the film forming unit,
wherein the nozzle comprises at least two or more opposing gas inlets, a gas mixing unit comprising the gas inlets, and a gas outlet from which the mist is sprayed, and
the atomizer and the gas inlets of the gas mixing unit are coupled to each other by piping, the piping further comprising a portion adjacent to the gas inlets having a smaller inner diameter than an inner diameter of the piping upstream thereof.

7. The film forming apparatus according to claim 6, wherein the gas mixing unit has a volume V (cm³) satisfying V>250.

8. A film forming method that sprays mist on a heated substrate from a nozzle to form a crystalline oxide film by a mist CVD method,
wherein the nozzle for use in the method comprises at least two or more opposing gas inlets, a gas mixing unit comprising the gas inlets, and a gas outlet from which the mist is sprayed, and
a linear velocity of the mist is increased adjacent to the gas inlets.

9. The film forming method according to claim 8, wherein a linear velocity L (cm/sec) of the mist at any one of the two or more opposing gas inlets satisfies L≥0.8V-200, wherein V (cm³) represents a volume of the gas mixing unit.

10. The film forming method according to claim 9,
wherein the gas mixing unit for use in the method has the volume V (cm³) satisfying V>250.

11. The film forming method according to any one of claims 8 to 10, wherein the substrate for use in the method has a diameter of 100 mm to 200 mm.

12. The film forming method according to any one of claims 8 to 10, wherein the crystalline oxide film comprises gallium oxide as a main component.

13. The film forming method according to claim 11, wherein the crystalline oxide film comprises gallium oxide as a main component.
